# FASCICULE DE BREVET EUROPEEN

(11) **EP 4 142 149 B1**
(45) Date de publication et mention de la délivrance du brevet: **22.04.2026**
(21) Numéro de dépôt: 22190777.7
(22) Date de dépôt: 17.08.2022
(51) Int. Cl.: H03B 19/14

(54) **DOUBLEUR ET TRIPLEUR RADIOFREQUENCE**
FUNKFREQUENZ-VERDOPPLER UND -VERDREIFACHER
RADIO FREQUENCY DOUBLER AND TRIPLER

(30) Priorité: 26.08.2021 FR 2108930
(43) Date de publication de la demande: 01.03.2023
(73) Titulaire: STMicroelectronics France, 92120 Montrouge (FR)
(72) Inventeur: VOGT, Lionel, 73110 LA ROCHETTE (FR)
(74) Mandataire: Cabinet Beaumont

(56) Documents cités:
- FR-A1- 2 828 350
- US-A1- 2005 093 588
- US-A1- 2009 160 502

## Description

### Domaine technique

La présente description concerne de façon générale les circuits électroniques, et, plus particulièrement un doubleur et un tripleur de fréquence d'un signal radiofréquence.

### Technique antérieure

Un doubleur radiofréquence ("radiofrequency doubler" en anglais), respectivement un tripleur radiofréquence ("radiofrequency tripler" en anglais), est un circuit configuré pour recevoir un signal radiofréquence d'entrée et pour fournir un signal de sortie dont la fréquence est égale à deux fois, respectivement trois fois, la fréquence du signal d'entrée. A titre d'exemple, la fréquence du signal d'entrée est supérieure ou égale à 1 GHz, voire supérieure ou égale à 10 GHz, voire encore supérieure ou égale à 20 GHz. Le documents US 2005/093588 A1 présente un exemple d'un doubleur de fréquence, le document FR 2 828 350 A1 présente des exemples d'un doubleur de fréquence et le document US 2009/160502 A1 présente des exemples de multiplieurs de fréquence.

Les doubleurs radiofréquences et les tripleurs radiofréquences connus présentent divers inconvénients.

### Résumé de l'invention

Il existe un besoin pour un doubleur radiofréquence palliant au moins certains inconvénients des doubleurs radiofréquences connus.

Il existe également un besoin un pour tripleur radiofréquence palliant au moins certains inconvénients des tripleur radiofréquence connus.

Un mode de réalisation pallie tout ou partie des inconvénients des doubleurs radiofréquences connus.

Un mode de réalisation pallie tout ou partie des inconvénients des tripleurs radiofréquences connus.

Un mode de réalisation prévoit un doubleur radiofréquence comprenant :
un premier transistor et un deuxième transistor connectés en parallèle entre une première sortie différentielle et une première borne d'une source de courant configurée pour fournir un courant de polarisation, une deuxième borne de la source de courant étant connectée à un potentiel d'alimentation, de préférence la masse ;
un troisième transistor connecté entre la première borne de la source de courant et une deuxième sortie différentielle ;
un circuit configuré pour :
   - appliquer une composante alternative d'une première entrée différentielle et une première tension continue à la grille du premier transistor,
   - appliquer une composante alternative d'une deuxième entrée différentielle et la première tension continue à la grille du deuxième transistor, et
   - appliquer une deuxième tension continue à la grille du troisième transistor ; et
une boucle de contre réaction configurée pour asservir la première tension ou la deuxième tension à partir d'un écart entre les composantes continues des première et deuxième sorties différentielles de manière à rendre égale lesdites composantes continues.

Selon un mode de réalisation, la boucle de contre réaction est configurée pour fournir une tension de sortie représentative dudit écart.

Selon un mode de réalisation, la boucle de contre réaction comprend une première entrée couplée, par exemple connectée, à la première sortie différentielle, une deuxième entrée couplée, par exemple connectée, à la deuxième sortie différentielle et une sortie configurée pour fournir ladite tension de sortie.

Selon un mode de réalisation, la boucle de contre réaction comprend :
un amplificateur opérationnel ;
une capacité connectée entre une entrée non inverseuse de l'amplificateur et ledit potentiel d'alimentation ;
une capacité connectée entre une entrée inverseuse de l'amplificateur et une sortie de l'amplificateur ;
une première résistance couplant l'entrée non inverseuse à la première entrée de la boucle de contre réaction lorsque la première tension est asservie par la boucle de contre réaction,
ou à la deuxième entrée de la boucle de contre réaction lorsque la deuxième tension est asservie par la boucle de contre réaction ; et
une deuxième résistance couplant l'entrée inverseuse à la deuxième entrée de la boucle de contre réaction lorsque la première tension est asservie par la boucle de contre réaction,
ou à la deuxième entrée de la boucle de contre réaction lorsque la deuxième tension est asservie par la boucle de contre réaction.

Selon un mode de réalisation, le circuit est configuré pour fournir la première tension à partir de la tension de sortie de la boucle de contre réaction lorsque la première tension est asservie par la boucle de contre réaction, ou pour fournir la deuxième tension à partir de la tension de sortie de la boucle de contre réaction lorsque la deuxième tension est asservie par la boucle de contre réaction.

Selon un mode de réalisation, le circuit est configuré pour recevoir la tension de sortie de la boucle de contre réaction.

Selon un mode de réalisation, ledit circuit comprend une sortie connectée à la grille du troisième transistor, ladite sortie étant configurée pour fournir la tension de sortie de la boucle lorsque la deuxième tension est asservie par la boucle de contre réaction ou une tension de polarisation constante lorsque la première tension est asservie par la boucle de contre réaction.

Selon un mode de réalisation, le circuit comprend :
une première capacité couplant la première entrée différentielle à la grille du premier transistor ;
une deuxième capacité couplant la deuxième entrée différentielle à la grille du deuxième transistor ;
une première résistance couplant la grille du premier transistor à un premier noeud configuré pour recevoir la tension de sortie de la boucle de contre réaction lorsque la première tension est asservie par ladite boucle ou la tension de polarisation lorsque la deuxième tension est asservie par ladite boucle ;
une deuxième résistance couplant la grille du deuxième transistor au premier noeud ; et
une troisième capacité couplant le premier noeud audit potentiel d'alimentation.

Selon un mode de réalisation, le circuit comprend un transformateur ayant son primaire couplé aux première et deuxième entrées différentielles, et son secondaire couplé aux grilles des premier et deuxième transistors, le secondaire étant configuré pour être polariser par la tension de sortie de la boucle de contre réaction lorsque la première tension est asservie par ladite boucle ou par la tension de polarisation lorsque la deuxième tension est asservie par ladite boucle.

Selon un mode de réalisation, le circuit comprend une quatrième capacité couplant ladite sortie du circuit au potentiel d'alimentation.

Un autre mode de réalisation prévoit un tripleur radiofréquence comprenant :
un doubleur radiofréquence tel que décrit ; et
un mélangeur radiofréquence configuré pour mélanger un premier signal radiofréquence et un deuxième signal radiofréquence, le mélangeur radiofréquence comprenant une première paire d'entrées différentielles configurées pour recevoir le premier signal et une deuxième paire d'entrées différentielles configurées pour recevoir le deuxième signal, dans lequel la première paire d'entrées différentielles est connectée aux première et deuxième entrées différentielles du doubleur radiofréquence, et la deuxième paire d'entrées différentielles est connectée aux première et deuxième sorties différentielles du doubleur radiofréquence.

Selon un mode de réalisation, le mélangeur radiofréquence comprend :
un premier transistor connecté entre une première entrée de la deuxième paire d'entrées et une première sortie différentielle du tripleur radiofréquence ;
un deuxième transistor connecté entre la première entrée de la deuxième paire d'entrées et une deuxième sortie différentielle du tripleur radiofréquence ;
un troisième transistor connecté entre une deuxième entrée de la deuxième paire d'entrées et la première sortie du tripleur radiofréquence ; et
un quatrième transistor connecté entre la deuxième entrée de la deuxième paire d'entrées et la deuxième sortie du tripleur radiofréquence.

Selon un mode de réalisation :
une première entrée de la première paire d'entrées différentielles est couplée, par exemple connectée, à la grille dudit premier transistor et à la grille dudit quatrième transistor ; et
une deuxième entrée de la première paire d'entrées différentielles est couplée, par exemple connectée, à la grille dudit deuxième transistor et à la grille dudit troisième transistor.

Selon un mode de réalisation, le mélangeur comprend une charge différentielle couplée entre les première et deuxième sorties différentielles du tripleur radiofréquence et accordée à une fréquence égale à trois fois une fréquence du premier signal radiofréquence, la charge différentielle comprenant, par exemple :
une capacité connectée entre les première et deuxième sorties différentielles du tripleur radiofréquence ;
une première inductance connectée entre la première sortie différentielle du tripleur radiofréquence et un noeud configuré pour recevoir un potentiel d'alimentation ; et
une deuxième inductance connectée entre la deuxième sortie différentielle du tripleur radiofréquence et ledit noeud.

Un autre mode de réalisation prévoit une chaine d'émission et/ou de réception radiofréquence comprenant un doubleur radiofréquence ou un tripleur radiofréquence tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique et sous la forme de blocs, un mode de réalisation d'un doubleur radiofréquence ;
la figure 2 représente, de manière plus détaillée, un exemple de mode de réalisation du doubleur radiofréquence de la figure 1 ;
la figure 3 représente, de manière plus détaillée, un autre exemple de mode de réalisation du doubleur radiofréquence de la figure 1 ;
la figure 4 représente, de manière schématique et sous la forme de blocs, un mode de réalisation d'un tripleur radiofréquence ;
la figure 5 représente, de manière plus détaillée, un exemple de mode de réalisation du tripleur radiofréquence de la figure 5 ; et
la figure 6 représente, de manière schématique, partielle et sous la forme de bloc, un mode de réalisation d'un chaîne d'émission ou de réception radiofréquence.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les divers circuits usuels comprenant un doubleur radiofréquence ou un tripleur radiofréquence n'ont pas été détaillés, les modes de réalisation décrits étant compatibles avec ces circuits usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

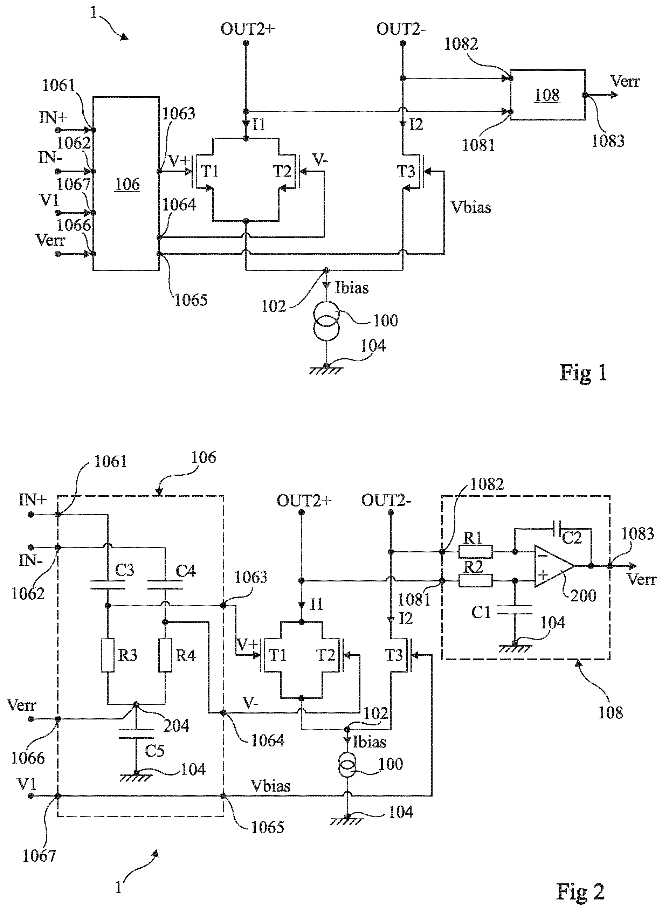

La figure 1 représente, de manière schématique et au moins partiellement sous la forme de blocs, un mode de réalisation d'un doubleur radiofréquence 1.

Le doubleur radiofréquence 1 est configuré pour recevoir un signal radiofréquence différentiel à une première fréquence F1, et pour fournir un signal radiofréquence différentiel à une deuxième fréquence F2 égale au double de la première fréquence. Dit autrement, le doubleur radiofréquence est configuré pour doubler la fréquence F1 d'un signal radiofréquence différentiel.

Le doubleur radiofréquence 1 comprend une paire d'entrées différentielles IN+ et IN-. L'entrée IN+ est configurée pour recevoir un signal radiofréquence, l'entrée IN- étant configurée pour recevoir un signal radiofréquence correspondant au signal radiofréquence reçu par l'entrée IN+ déphasé de 180°. La paire d'entrées IN+ et IN- est configurée pour recevoir signal radiofréquence différentiel d'entrée dont on souhaite doubler la fréquence F1.

Le doubleur radiofréquence 1 comprend une paire de sorties différentielles OUT2+ et OUT2-. La sortie OUT2+ est configurée pour fournir un signal radiofréquence à la fréquence F2 égale au double de la fréquence F1 du signal reçu par la paire d'entrées IN+ et IN-. La sortie OUT2- est configurée pour fournir un signal radiofréquence correspondant au signal sur la sortie OUT2+ déphasé de 180°. Dit autrement, la paire de sorties OUT2+ et OUT2- est configurée pour fournir un signal radiofréquence différentiel de sortie à la fréquence F2.

Les sorties OUT2+ et OUT2- sont destinées à être connectées à une charge de sorte que l'impédance vue par le doubleur radiofréquence 1 sur sa sortie OUT2+ soit égale à l'impédance vue par le doubleur radiofréquence 1 sur sa sortie OUT2-, comme cela est usuel pour les transmissions de signaux différentiels.

Le doubleur radiofréquence 1 comprend une source de courant 100. La source de courant 100 est configurée pour fournir un courant de polarisation Ibias. Le courant Ibias est constant. La source de courant 100 comprend une première borne 102 et une deuxième borne 104, la borne 104 étant couplée, par exemple connectée, à un potentiel d'alimentation, dans cet exemple la masse. Dit autrement, la borne 104 est couplée, par exemple connectée, à un noeud 106 configuré pour recevoir ce potentiel d'alimentation.

Le doubleur radiofréquence 1 comprend un transistor MOS ("Metal Oxide Semiconductor" - Métal Oxyde Semiconducteur) T1, et un transistor MOS T2. Dans cet exemple, les transistors T1 et T2 sont à canal N. De préférence, les transistors T1 et T2 sont identiques.

Les transistors T1 et T2 sont connectés en parallèle entre la borne 102 de la source de courant 100 et l'une des sorties OUT2+ et OUT2-, dans cet exemple la sortie OUT2+.

Les transistors T1 et T2 sont configurés pour être commandés en opposition de phase à partir des entrées IN+ et IN-. Plus particulièrement, la grille du transistor T1 est configurée pour recevoir une tension V+, la grille du transistor T2 étant configurée pour recevoir une tension V-. La tension V+ est obtenue à partir de l'entrée IN+, la tension V- étant obtenue à partir de l'entrée IN-. Les tensions V+ et V- sont en opposition de phase, et à la fréquence F1. A titre d'exemple, le circuit 106 comprend une entrée 1061 connectée à l'entrée IN+, une entrée 1062 connectée à l'entrée IN-, une sortie 1063 configurée pour fournir la tension V+, une sortie 1064 configurée pour fournir la tension V- et une sortie 1065 configurée pour fournir la tension Vbias.

Le doubleur radiofréquence 1 comprend un transistor MOS T3. Le transistor T3 est à canal du même type que les transistors T1 et T2, à savoir à canal N dans cet exemple. De préférence, le transistor T3 est identique aux transistors T1 et T2.

Le transistor T3 est configuré pour être commandé par une tension continue (DC) Vbias.

Le doubleur radiofréquence 1 comprend un circuit 106 configuré pour fournir les tensions V+, V- et Vbias.

Plus particulièrement, le circuit 106 est configuré pour que la tension V+ soit égale à la composante alternative (AC) du signal, ou tension, reçu sur l'entrée IN+ plus une tension VDC continue (DC), et que la tension V- soit égale à la composante alternative (AC) du signal, ou tension, reçu sur l'entrée IN- plus la tension VDC. Dit autrement, le circuit 106 est configuré pour coupler l'entrée IN+, respectivement IN-, à la grille du transistor T1, respectivement T2, de sorte que seule la composante alternative (AC) de la tension IN+, respectivement IN-, soit transmise à la grille du transistor T1, respectivement T2, et, en outre, pour appliquer simultanément aux grilles des transistors T1 et T2 la composante continue (DC) VDC.

Il est ici proposé d'asservir, ou déterminer, la tension VDC ou la tension Vbias à partir d'une différence, ou écart, entre la composante continue (DC) sur la sortie OUT2+ et la composante continue (DC) sur la sortie OUT2-, de manière que la composante continue (DC) sur la sortie OUT2+ soit égale à la composant continue (DC) sur la sortie OUT2-, ou, dit autrement, que le courant continu (DC) dans la branche comprenant les transistors T1 et T2 soit égal au courant continu (DC) dans la branche comprenant le transistor T3.

Plus particulièrement, selon un mode de réalisation, la tension VDC, c'est-à-dire la composante continue des tensions V+ et V-, est asservie à partir de la différence entre les composantes continues (DC) des sorties OUT2+ et OUT2-. Dans ce mode de réalisation, la tension Vbias est constante. A titre d'exemple, la tension Vbias est alors déterminée par une tension de polarisation V1 continue (DC) et constante. Par exemple, la tension Vbias est alors égale à la tension V1.

Selon un autre mode de réalisation, la tension Vbias est asservie à partir de la différence entre les composantes continues (DC) des sorties OUT2+ et OUT2-. Par exemple, la tension Vbias est alors égale à la tension Verr. Dans ce mode de réalisation, la tension VDC, c'est-à-dire la composante continue (DC) des tensions V+ et V-, est constante. A titre d'exemple, la tension VDC est alors déterminée par la tension V1.

Pour mettre en œuvre cet asservissement, le doubleur radiofréquence 1 comprend une boucle de contre réaction 108. La boucle de contre réaction 108 est configurée pour déterminer, ou asservir, la tension VDC ou la tension Vbias de manière à rendre égale les composantes continues (DC) des sorties OUT2+ et OUT2-.

Selon un mode de réalisation, la boucle de contre réaction 108 est configurée pour fournir une tension Verr de sortie de la boucle de contre réaction 108. La tension Verr est représentative de la différence entre les composantes continues (DC) des sorties OUT2+ et OUT2-. Dit autrement, la valeur de la tension Verr varie avec la différence de valeur entre les composantes continues (DC) des sorties OUT2+ et OUT2-. Dit encore autrement, la valeur de la différence entre les composantes continues (DC) des sorties OUT2+ et OUT2-détermine la valeur de la tension Verr. Plus particulièrement, la boucle de contre réaction 108 comprend, par exemple, une entrée 1081 couplée, de préférence connectée, à la sortie OUT2+, une entrée 1082 couplée, de préférence connectée, à la sortie OUT2- et une sortie 1083 configurée pour fournir la tension Verr.

Selon un mode de réalisation, le circuit 106 est configuré pour fournir la tension VDC, c'est-à-dire la composante continue des tensions V+ et V-, à partir de la tension Verr. A titre d'exemple, dans un tel mode de réalisation, le circuit 106 est configuré pour fournir la tension Vbias constante à partir de la tension V1, par exemple de sorte que la tension Vbias soit égale à la tension V1.

Selon un autre mode de réalisation, le circuit 106 est configuré pour fournir la tension Vbias à partir de la tension Verr, par exemple de sorte que la tension Vbias soit égale à la tension Verr. A titre d'exemple, dans un tel mode de réalisation, le circuit 106 est configuré pour fournir la tension VDC constante à partir de la tension V1. Dit autrement, le circuit 106 est configuré pour que la tension VDC soit constante et déterminée, ou fixée, par la tension constante V1.

Le circuit 106 est donc configuré pour recevoir la tension Verr. A titre d'exemple, le circuit 106 a une entrée 1066 configurée pour recevoir la tension Verr. L'entrée 106 est couplée, de préférence connectée, à la sortie 1083 de la boucle de contre réaction 108. De préférence, le circuit 106 est en outre configuré pour recevoir la tension V1, par exemple sur une entrée 1067 du circuit 106.

Comme cela a été indiqué précédemment, le circuit 106 est configuré pour coupler l'entrée IN+, respectivement IN-, à la grille du transistor T1, respectivement T2, de sorte que seule la composante alternative (AC) de la tension IN+, respectivement IN-, soit transmise à la grille du transistor T1, respectivement T2. Dit autrement, le circuit 106 est configuré pour coupler son entrée 1061, respectivement 1062, a sa sortie 1063, respectivement 1064, en mettant en œuvre un filtrage de la composante continue (DC), ou filtrage DC, entre l'entrée 1061 et la sortie 1063, respectivement entre l'entrée 1062 et la sortie 1064.

Pour décrire le fonctionnement du doubleur radiofréquence 1, on considère, à titre d'exemple, le mode de réalisation dans lequel la tension VDC est asservie à partir de la tension Verr, et dans lequel la tension Vbias est fixe et, par exemple, égale à la tension V1.

Dans le doubleur radiofréquence 1, dans la branche comprenant les transistors T1 et T2, les transistors T1 et T2 sont commandés par des tensions V+ et V- qui sont en opposition de phase l'une par rapport à l'autre, et qui ont la même composante continue VDC. Ainsi, dès lors que les tensions V+ et V- ont des amplitudes suffisantes pour exploiter le fonctionnement non-linéaire, dit "grand signal", des transistors T1 et T2, par exemple des amplitudes de l'ordre de plusieurs centaines de millivolts, un courant I1 dans la branche comprenant les transistors T1 et T2 a une composante à une fréquence égale à F2. En outre, la somme du courant I1 dans la branche comprenant les transistors T1 et T2 et du courant I2 dans la branche comprenant le transistor T3 est égale au courant constant Ibias. Ainsi, le courant I2 est en opposition de phase par rapport au courant I1, et a également une composante à la même fréquence F2 que le courant I1.

On considère en outre, à titre d'exemple, que la composante continue (DC) de tension sur la sortie OUT2+ est inférieure à la composante continue (DC) de tension sur la sortie OUT2-. Dit autrement, la valeur moyenne, c'est-à-dire la composante continue (DC), du courant I1 est supérieure à la valeur moyenne, c'est-à-dire la composante continue (DC), du courant I2, par exemple, du fait du fonctionnement en régime non-linéaire des transistors T1 et T2. Dit encore autrement, on considère que les sorties OUT2+ et OUT2- sont déséquilibrées. Ce déséquilibre se traduit par une modification correspondante, par exemple une diminution, de la valeur de la tension Verr par rapport à la valeur de la tension Verr lorsque les sorties OUT2+ et OUT2- sont équilibrées. La composante VDC des tensions V+ et V-, qui est asservie par la boucle de contre réaction 108, donc par la tension Verr, est alors modifiée, par exemple diminuée dans l'exemple illustré en figure 1, en conséquence de la diminution de la tension Verr. Il en résulte que la valeur moyenne du courant I1 diminue, jusqu'à redevenir égale à la valeur moyenne du courant I2, c'est-à-dire jusqu'à ce que les sortie OUT2+ et OUT2- s'équilibrent. En même temps que la valeur moyenne du courant I1 se rapproche de celle du courant I2, la valeur de tension Verr se stabilise.

On a décrit ci-dessus le fonctionnement du doubleur de fréquence 1 lorsque le déséquilibre entre les sorties OUT2+ et OUT2- correspond au cas où la composante continue (DC) de tension sur la sortie OUT2+ est supérieure à celle sur la sortie OUT2-, et la tension VDC est asservie par la boucle de contre réaction 108. La personne du métier est en mesure de déduire de cette description le fonctionnement du doubleur radiofréquence 1 lorsque que le déséquilibre entre les sorties OUT2+ et OUT2- correspond au cas où la composante continue (DC) de tension sur la sortie OUT2+ est inférieure à celle sur la sortie OUT2-, et/ou la tension Vbias est asservie par la boucle de contre réaction 108 alors que la tension composante continue VDC des tensions V+ et V- est fixée, par exemple par la tension V1.

Le doubleur radiofréquence 1 permet donc d'obtenir des sorties OUT2+ et OUT2- équilibrées. Cela permet avantageusement de maximiser l'amplitude de composante à la fréquence recherchée F2, tout en équilibrant les sorties OUT2+ et OUT2-.

Le doubleur radiofréquence 1 permet d'obtenir cet équilibre des sortie OUT2+ et OUT2- sans recourir à quatre signaux de commande ayant la même fréquence F1 que le signal sur les entrées IN+ et IN- et présentant des déphasages par rapport au signal sur les entrées IN+ et IN- égaux respectivement à 0°, 90°, 180° et 270°, ce qui aurait nécessité la prévision d'un filtre polyphase encombrant et introduisant des pertes aux fréquences considérées.

Le doubleur radiofréquence 1 permet d'obtenir une composante à la fréquence F2 double de la fréquence F1 sans recourir non plus à une boucle à verrouillage de phase (PLL - "Phase Locked Loop"), la mise en œuvre d'une telle PLL étant complexe, voire impossible, aux fréquences considérées.

Le doubleur radiofréquence 1 permet d'obtenir une composante à la fréquence F2 double de la fréquence F1 sans recourir non plus à un oscillateur verrouillé en injection ("Injection-Locked Oscillator") qui a une plage de verrouillage très étroite et peut facilement se déverrouiller aux fréquences considérées.

Plus généralement, par rapport aux doubleurs radiofréquence usuels, le doubleur radiofréquence 1 est particulièrement simple et peu encombrant à mettre en œuvre.

La figure 2 représente, de manière plus détaillée, un exemple de mode de réalisation du doubleur radiofréquence 1. En figure 2, le doubleur radiofréquence 1 est mis en œuvre selon un mode de réalisation dans lequel la composante continue (DC) VDC des tensions V+ et V- est asservie par la boucle de phase 108, la tension Vbias étant alors constante et, dans cet exemple, égale à la tension de polarisation V1.

Plus particulièrement, en figure 2, un exemple de mode de réalisation de la boucle de contre réaction 108 est détaillé et un mode de réalisation du circuit 106 est détaillé, le reste du doubleur radiofréquence 1 étant identique à ce qui a été décrit en relation avec la figure 1. En outre, on notera que la façon dont est mise en œuvre la boucle de contre réaction 108 est indépendante de la façon dont est mis en œuvre le circuit 106, dès lors que le circuit 106 est configuré pour fournir la composante continue (DC) VDC des tensions V+ et V- à partir de la tension Verr de manière à mettre en œuvre le fonctionnement décrit précédemment du doubleur radiofréquence 1.

En figure 2, la boucle de contre réaction 108 est mise en œuvre par un intégrateur différentiel.

Plus particulièrement, en figure 2, la boucle de contre réaction 108 comprend un amplificateur opérationnel 200. Une capacité C1 est connectée entre une entrée non inverseuse (+) de l'amplificateur 108 et le potentiel d'alimentation du noeud 104, à savoir la masse dans l'exemple de la figure 2. Dit autrement, la capacité C1 est connectée entre l'entrée non inverseuse et le noeud 104. Une capacité C2 est connectée entre une entrée inverseuse (-) de l'amplificateur 200 et une sortie de l'amplificateur. La sortie de l'amplificateur 200 est configurée pour fournir la tension Verr. A titre d'exemple, la sortie de l'amplificateur 200 est connectée à la sortie 1083 de la boucle de contre réaction.

En outre, en figure 2, la boucle de contre réaction 108 comprend des résistances R1 et R2 couplant les entrées de l'amplificateur 200 aux entrées 1081 et 1082 de la boucle de contre réaction. Dans ce mode de réalisation où la tension VDC est déterminée par la boucle de contre réaction 108, la résistance R1 couple l'entrée inverseuse à l'entrée 1082 et la résistance R2 couple l'entrée non inverseuse à l'entrée 1081. A titre d'exemple, la résistance R1 a une borne connectée à l'entrée inverseuse de l'amplificateur 200 et une autre borne connectée à l'entrée 1082 de la boucle de contre réaction, la résistance R2 ayant une borne connectée à l'entrée non inverseuse de l'amplificateur 200 et une autre borne connectée à l'entrée 1081 de la boucle de contre réaction.

Par ailleurs, en figure 2, le circuit 106 comprend une capacité C3 couplant l'entrée différentielle IN+ à la grille du transistor T1, et une capacité C4 couplant l'entrée différentielle IN- à la grille du transistor T2. Par exemple, la capacité C3 est connectée entre l'entrée 1061 et la sortie 1063 du circuit 106, la capacité C4 étant connectée entre l'entrée 1062 et la sortie 1064 du circuit 106. La capacité C3, respectivement C4, est configurée pour filtrer la composante continue (DC) entre l'entrée 1061 et la sortie 1063 du circuit 106, respectivement entre l'entrée 1062 et la sortie 1064 du circuit 106. De préférence, les capacités C3 et C4 ont une même valeur de capacité.

En figure 2, le circuit 106 comprend en outre, une résistance R3 couplant la grille du transistor T1, c'est-à-dire la sortie 1063 du circuit 106, à un noeud 204, et une résistance R4 couplant la grille du transistor T2, c'est-à-dire la sortie 1064 du circuit 106, au noeud 204. Par exemple, la résistance R3, respectivement R4, a une borne connectée à la grille du transistor T1, respectivement T2, et une autre borne connectée au noeud 204. Une capacité C5 couple le noeud 204 au potentiel d'alimentation du noeud 104. Par exemple, la capacité C5 est connectée entre les noeuds 104 et 204.

Dans ce mode de réalisation où la tension VDC est asservie par la boucle de contre réaction 108, le noeud 204 est configuré pour recevoir la tension Verr de sortie de la boucle de contre réaction 108, le noeud 108 étant par exemple connecté à la sortie 1083 de la boucle de contre réaction 108. Ainsi, lorsque la tension Verr varie, cela entraîne une variation correspondante de la composante continue (DC) VDC des tensions V+ et V-. En outre, dans ce mode de réalisation, la sortie 1065 du circuit 106 est configurée pour que la tension Vbias qu'elle fournit soit égale à la tension V1. Dit autrement, la sortie 1065 du circuit 106 est configurée pour recevoir la tension V1 et fournir la tension Vbias. A titre d'exemple, l'entrée 1067 du circuit 106 est alors connectée à la sortie 1065 du circuit 106.

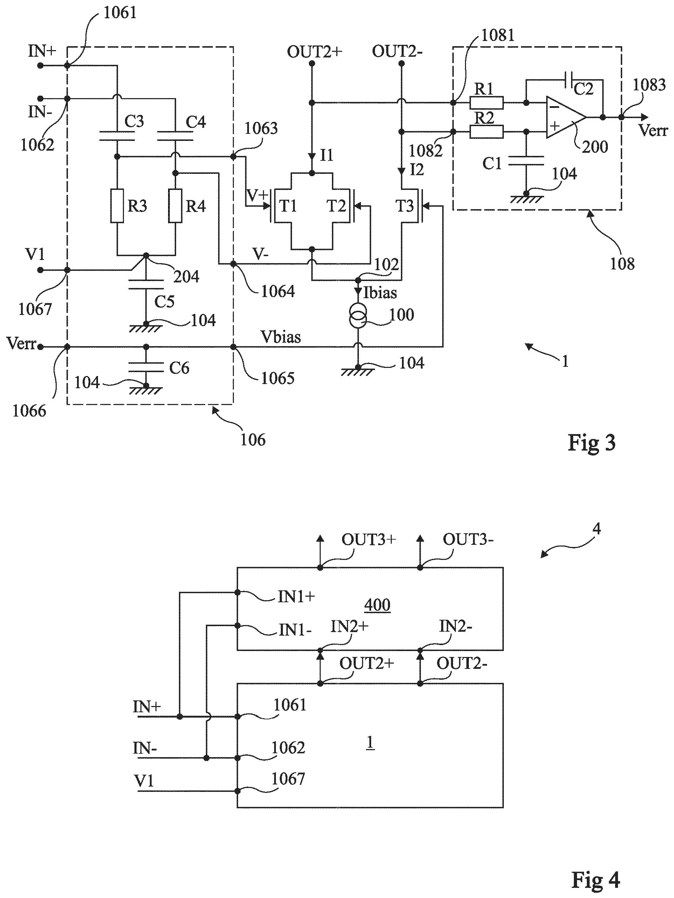

La figure 3 représente, de manière plus détaillée, un autre exemple de mode de réalisation du doubleur radiofréquence de la figure 1. En figure 3, le doubleur radiofréquence 1 est mis en œuvre selon un mode de réalisation dans lequel la tension Vbias est asservie par la boucle de phase 108, la composante continue (DC) VDC des tensions V+ et V- étant alors constante et, dans cet exemple, fixée par la tension de polarisation V1. Dans l'exemple de la figure 3, la tension Vbias est égale à la tension Verr.

Plus particulièrement, en figure 3, un exemple de mode de réalisation de la boucle de contre réaction 108 est détaillé, un mode de réalisation du circuit 106 est détaillé, le reste du doubleur radiofréquence 1 étant identique à ce qui a été décrit en relation avec la figure 1. En outre, on notera que la façon dont est mise en œuvre la boucle de contre réaction 108 est indépendante de la façon dont est mis en œuvre le circuit 106, dès lors que le circuit 106 est configuré pour fournir la tension Vbias à partir de la tension Verr de manière à mettre en œuvre le fonctionnement décrit précédemment en relation avec la figure 1.

Le doubleur radiofréquence 1 de la figure 3 comprend de nombreux éléments en commun avec celui de la figure 2, et seules les différences entre ces deux figures sont ici mises en exergue.

A la différence de la figure 2, dans le mode de réalisation de la figure 3 où la tension Vbias est asservie par la boucle de contre réaction 108, la résistance R1 couple l'entrée inverseuse de l'amplificateur 200 à l'entrée 1081 de la boucle de contre réaction 106, et la résistance R2 couple l'entrée non inverseuse de l'amplificateur 200 à l'entrée 1082 de la boucle de contre réaction 106. A titre d'exemple, la résistance R1 a une borne connectée à l'entrée inverseuse de l'amplificateur 200 et une autre borne connectée à l'entrée 1081 de la boucle de contre réaction, la résistance R2 ayant une borne connectée à l'entrée non inverseuse de l'amplificateur 200 et une autre borne connectée à l'entrée 1082 de la boucle de contre réaction.

En outre, dans ce mode de réalisation où la tension Vbias est asservie par la boucle de contre réaction 108, le noeud 204 est configuré pour recevoir la tension V1, et la sortie 1065 du circuit 106 est configurée pour que la tension Vbias qu'elle fournit soit égale à la tension Verr. Ainsi, lorsque la tension Verr varie, cela entraîne une variation correspondante de la Vbias. Dit autrement, la sortie 1065 du circuit 106 est configurée pour recevoir la tension Verr et fournir la tension Vbias. A titre d'exemple, l'entrée 1066 du circuit 106 est alors connectée à la sortie 1065 du circuit 106. De préférence, dans ce mode de réalisation, une capacité C6 couple la sortie 1065 du circuit 106 au potentiel du noeud 104, la capacité C6 étant, par exemple, connectée entre la sortie 1065 et le noeud 104.

Bien que l'on ait décrit ci-dessus en relation avec les figures 2 et 3 des modes de réalisation particuliers du circuit 106, la personne du métier est en mesure de prévoir d'autres implémentations de ce circuit à partir de la description fonctionnelle de ce circuit 106 faite en relation avec la figure 1. Par exemple, selon un autre mode de réalisation non illustré, le circuit 106 comprend un transformateur ayant son primaire couplé aux entrées différentielles IN+ et IN-, et son secondaire couplé aux grilles des transistors T1 et T2. Dans un mode de réalisation où la composante continue (DC) VDC des tensions V+ et V- est asservie par la boucle de contre réaction 108, le secondaire du transformateur est alors configuré pour être polarisé par la tension Verr. Dans un autre mode de réalisation où la tension Vbias est asservie par la boucle de contre réaction 108, le secondaire du transformateur est alors configuré pour être polarisé par la tension V1.

De plus, bien que l'on ait décrit ci-dessus en relation avec les figures 2 et 3 des modes de réalisation particuliers de la boucle de contre 108 dans lesquels la boucle de contre réaction 108 est mise en œuvre à partir d'un intégrateur différentiel, la personne du métier est en mesure de prévoir d'autres implémentations de cette boucle de contre réaction 108 à partir de la description fonctionnelle de cette boucle de contre réaction 108 faite en relation avec la figure 1. Par exemple, selon un autre mode de réalisation non illustré, la boucle de contre réaction 108 est mise en œuvre au moyen d'un amplificateur d'erreur.

Du fait que le doubleur radiofréquence 1 décrit en relation avec la figure 1, la figure 2 ou la figure 3 a ses sorties différentielles OUT2+ et OUT2- équilibrées grâce à la boucle de contre réaction 108, le doubleur radiofréquence 1 est, par exemple, adapté à une utilisation dans un tripleur radiofréquence, bien que le doubleur radiofréquence 1 puisse également être utilisé seul. Par exemple, lorsque le doubleur radiofréquence 1 est utilisé seul, c'est-à-dire pour fournir une composante à la fréquence F2, ses sorties OUT2+ et OUT2-sont alors couplées à une charge différentielle adaptée, ou accordée, à la fréquence F2 comme cela est usuel pour la personne du métier.

La figure 4 représente, de manière schématique et sous la forme de blocs, un mode de réalisation d'un tel tripleur radiofréquence 4. En particulier, en figure 4, le doubleur radiofréquence 1 est représenté sous la forme d'un bloc comprenant les entrées 1061, 1062 et, dans cet exemple, 1067, et comprenant en outre la paire de sorties différentielles OUT2+ et OUT2-.

En plus du doubleur radiofréquence 1, le tripleur radiofréquence 4 comprend un mélangeur radiofréquence 400, aussi appelé multiplieur radiofréquence 400. Le mélangeur de fréquence 400 est configuré pour mélanger (multiplier) un premier signal radiofréquence et un deuxième signal radiofréquence. Le signal de sortie du mélangeur 400 correspond à une multiplication des premier et deuxième signaux. Ainsi, la fréquence du signal de sortie du mélangeur est égale à la somme de la fréquence du premier signal et de la fréquence du deuxième signal.

Plus particulièrement, le mélangeur 400 comprend une première paire d'entrées différentielles IN1+ et IN1-configurées pour recevoir le premier signal, dans ce cas un premier signal différentiel, et une deuxième paire d'entrées différentielles IN2+ et IN2- configurées pour recevoir le deuxième signal-, dans ce cas un deuxième signal différentiel. Le mélangeur 400 comprend en outre une paire de sorties différentielles OUT3+ et OUT3- sur lesquelles est disponible le signal différentiel de sortie du mélangeur, le signal sur la sortie OUT3- étant déphasé de 180° par rapport au signal sur la sortie OUT3+.

En figure 4, la paire d'entrées différentielles IN1+ et IN1- est connectée aux entrées différentielles respectives IN+ et IN- du doubleur radiofréquence 1, et la paire d'entrées différentielles IN2+ et IN2- est connectée aux sorties différentielles respectives OUT2+ et OUT2- du doubleur radiofréquence 1. Ainsi, le signal de sortie du mélangeur 400 est à une fréquence F3 égale à la somme de la fréquence F1 du signal sur les entrées IN+ et IN- et de la fréquence F2 du signal sur les sorties OUT2+ et OUT2- du doubleur radiofréquence 1. Dit autrement, le signal de sortie du mélangeur est à la fréquence F3 qui est égale à trois fois la fréquence F1 du signal sur les entrées IN+ et IN-.

Un avantage que le doubleur radiofréquence 1 soit équilibré, c'est-à-dire que les sorties OUT2+ et OUT2- du doubleur radiofréquence 1 soient équilibrées, et que les pertes de puissance dans le tripleur de fréquence 4 sont limitées, en particulier à la fréquence F3. En outre, un autre avantage du fait que le doubleur radiofréquence 1 soit équilibré est que, dans le signal de sortie du tripleur radiofréquence 4, le rapport entre la puissance associée à la fréquence F3 et la puissance associée à la fréquence F1 est plus grand que dans le cas où le doubleur radiofréquence 1 serait remplacé par un doubleur radiofréquence usuel non équilibré.

Le tripleur radiofréquence 4 de la figure 4 est simple et peu encombrant à mettre en œuvre par rapport aux tripleurs radiofréquences usuels.

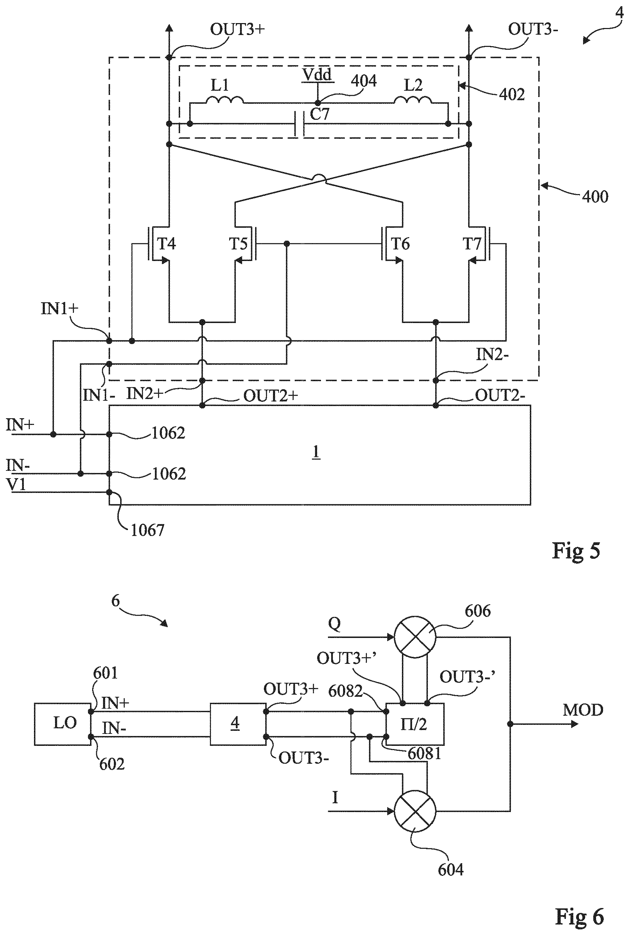

La figure 5 représente, de manière plus détaillée, un exemple de mode de réalisation du tripleur radiofréquence 4 de la figure 5. Plus particulièrement, la figure 5 représente de manière plus détaillée un exemple de mode de réalisation du mélangeur 400.

En figure 5, le mélangeur 400 comprend un transistor MOS T4 connecté entre l'entrée IN2+ de la paire d'entrées différentielles IN2+ et IN2- et la sortie OUT3+ du tripleur radiofréquence 4. A titre d'exemple, le transistor T4 a une première borne de conduction, par exemple sa source, connectée à l'entrée IN2+, et une deuxième borne de conduction, par exemple son drain, connectée à la sortie OUT3+. Le mélangeur 400 comprend en outre un transistor T5 connecté entre l'entrée IN2+ de la paire d'entrées différentielles IN2+ et IN2- et la sortie OUT3- du tripleur radiofréquence 4. A titre d'exemple, le transistor T5 a une première borne de conduction, par exemple sa source, connectée à l'entrée IN2+, et une deuxième borne de conduction, par exemple son drain, connectée à la sortie OUT3-. Le mélangeur 400 comprend également un transistor MOS T6 connecté entre l'entrée IN2- de la paire d'entrées différentielles IN2+ et IN2- et la sortie OUT3+ du tripleur radiofréquence 4. A titre d'exemple, le transistor T6 a une première borne de conduction, par exemple sa source, connectée à l'entrée IN2-, et une deuxième borne de conduction, par exemple son drain, connectée à la sortie OUT3+. Enfin, le mélangeur 400 comprend un transistor MOS T7 connecté entre l'entrée IN2- de la paire d'entrées différentielles IN2+ et IN2- et la sortie OUT3- du tripleur radiofréquence 4. A titre d'exemple, le transistor T7 a une première borne de conduction, par exemple sa source, connectée à l'entrée IN2-, et une deuxième borne de conduction, par exemple son drain, connectée à la sortie OUT3-. A titre d'exemple, dans ce mode de réalisation où le noeud 104 (figure 1) est configuré pour recevoir le potentiel de masse, les transistors T4, T5, T6 et T7 sont à canal N. De préférence, les transistors T4, T5, T6 et T7 sont identiques.

Les transistors T4 et T5 sont commandés en opposition de phase à partir du signal sur les entrées différentielles IN1+ et IN1-. De manière symétrique, les transistors T6 et T7 sont commandés en opposition de phase à partir du signal sur les entrées différentielles IN1+ et IN1-. Selon un mode de réalisation, l'entrée IN1+ de la première paire d'entrées différentielles IN1+ et IN1- est couplée, par exemple connectée, à la grille du transistor T4 et à la grille du transistor T7, l'entrée IN1- de la paire d'entrées différentielles IN1+ et IN1- étant couplée, par exemple connectée, à la grille du transistor T5 et à la grille du transistor T6.

Selon un mode de réalisation, le mélangeur 400 comprend en outre, entre ses sorties OU3+ et OUT3-, une charge différentielle 402. De préférence, la charge différentielle 402 est adaptée, ou accordée, à la fréquence F3, ce qui a pour effet de maximiser la puissance du signal différentiel de sortie à cette fréquence F3 tout en atténuant, ou filtrant, les composantes du signal différentiel de sortie aux autres fréquences non désirées. L'effet de filtrage naturellement obtenu par la charge différentielle 402 accordée à la fréquence F3 est bénéfique. Toutefois, l'équilibrage des sorties OUT2+ et OUT2- des sorties du doubleur radiofréquence 1 permet de réduire, ou minimiser, la composante à la fréquence F1 du signal différentiel de sortie du doubleur 1, donc du signal différentiel de sortie du tripleur 4, ce qui relâche, ou réduit, le besoin de filtrer cette composante F1 avec la charge différentielle 402.

Selon un mode de réalisation illustré en figure 5, la charge différentielle402 est mise en œuvre par une charge accordable ("tunable load" en anglais). La charge accordable 402 comprend, par exemple, une capacité C7 connectée entre les sorties différentielles OUT3+ et OUT3- du tripleur radiofréquence 4, une inductance L1 connectée entre la sortie différentielle OUT3+ du tripleur radiofréquence 4 et un noeud 404 configuré pour recevoir un potentiel d'alimentation Vdd différent de celui reçu par le noeud 104, par exemple positif par rapport à la masse, et une inductance L2 connectée entre la sortie différentielle OUT3- du tripleur radiofréquence 4 et le noeud 404.

La personne du métier est en mesure de prévoir d'autres mises en œuvre de la charge différentielle 402. Par exemple, selon un mode de réalisation non illustré, la charge différentielle 402 est mise en œuvre par un réseau d'adaptation d'impédance. Par exemple, selon un autre mode de réalisation non illustré, la charge différentielle 402 est mise en œuvre par un transformateur.

Le doubleur radiofréquence 1 ou le tripleur radiofréquence 4 précédemment décrits peuvent être utilisés dans de très nombreux circuits radiofréquences dans lesquels des signaux radiofréquences ayant des fréquences par exemple supérieures ou égales à 40 GHz, voire à 60 GHz, sont utilisés. C'est par exemple le cas dans les chaînes de réception et/ou d'émission d'un signal radiofréquence sans fil, par exemple une chaîne d'émission et/ou de réception conforme au standard 5G.

La figure 6 représente, de manière schématique, partielle et sous la forme de blocs, un mode de réalisation d'une telle chaîne d'émission 6.

La chaîne d'émission 6 comprend un circuit LO configuré pour fournir un signal radiofréquence différentiel à la fréquence F1. Le circuit, ou oscillateur local, LO à ses sorties différentielles 601 et 602 configurées pour fournir ce signal radiofréquence, qui sont connectées aux entrées différentielles respectives IN+ et IN- du tripleur radiofréquence 4. Le tripleur radiofréquence 4 fournit, sur ses sorties OUT3+ et OUT3-, un signal radiofréquence différentiel à la fréquence F3. Ce signal est, par exemple, fourni à un mélangeur de fréquence 604, sans avoir subi de déphasage, et à un autre mélangeur de fréquence 606 après avoir subi un déphasage de 90°. Plus particulièrement, la chaîne d'émission 6 comprend un circuit 608 (bloc "Π/2" en figure 6) configuré pour recevoir le signal de sortie du tripleur de fréquence 4 et pour fournir, au mélangeur 606, un signal correspondant au signal de sortie du tripleur de fréquence 4 déphasé de 90° par rapport à ce dernier. A titre d'exemple, le déphaseur 608 comprend une entrée 6081 connectée à la sortie OUT3- du tripleur radiofréquence 4, une entrée 6082 connectée à la sortie OUT3+ du tripleur radiofréquence 4, et deux sorties OUT3+' et OUT3-' formant une paire de sorties différentielles OUT3+' et OUT3-' du circuit 608. Le signal de sortie du circuit 608 est disponible sur les sorties OUT3+' et OUT3-'. Les sorties OUT3+' et OUT3-' sont par exemple connectées à des entrées différentielles correspondantes du mélangeur 606.

Le mélangeur 604 reçoit un signal de commande binaire I et le mélangeur 606 reçoit un signal de commande binaire Q. Les signaux I et Q sont, par exemple, fournis par un circuit numérique non représenté, et sont représentatifs de données à transmettre via un signal radiofréquence sans fil de la chaîne d'émission 6.

Les signaux de sorties des mélangeurs 604 et 606 sont combinés l'un avec l'autre pour former un signal radiofréquence modulé MOD. Ce signal MOD est ensuite émis à l'aide d'une antenne non illustrée.

Bien que l'on ait décrit la chaîne d'émission 6 dans le cas où elle comprend le tripleur radiofréquence 4, la mise en œuvre de la chaîne d'émission 6 dans le cas où le tripleur radiofréquence 4 est remplacé par le doubleur radiofréquence 1 est à la portée de la personne du métier.

En outre, bien que l'on ait décrit en relation avec la figure 6 le cas d'une chaîne d'émission, la personne du métier est en mesure de déduire de cette description la mise en œuvre d'une chaîne de réception correspondante. Par exemple, dans une telle chaîne de réception, le signal MOD est reçu par les mélangeurs 604 et 606, qui fournissent alors les signaux I et Q. Ces signaux I et Q sont, par exemple, transmis après une mise en forme à un circuit numérique configuré pour décoder les signaux I et Q, de manière à obtenir les données transmises via le signal MOD à cette chaîne de réception.

On a décrit précédemment des modes de réalisation dans lesquels le potentiel d'alimentation reçu par le noeud 104 est le potentiel de masse et le potentiel d'alimentation Vdd reçu par le noeud 404 décrit en relation avec la figure 5 est positif par rapport au potentiel de masse. La personne du métier est en mesure d'adapter cette description au cas où le noeud 104 reçoit le potentiel Vdd positif par rapport à la masse et le noeud 404 décrit en relation avec la figure 5 reçoit le potentiel de masse, par exemple en remplaçant tous les transistors MOS à canal N décrits par des transistors MOS à canal P.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Doubleur radiofréquence (1) comprenant :
un premier transistor (T1) et un deuxième transistor (T2) connectés en parallèle entre une première sortie différentielle (OUT2+) et une première borne (102) d'une source de courant (100) configurée pour fournir un courant de polarisation (Ibias), une deuxième borne de la source de courant (100) étant connectée à un potentiel d'alimentation, de préférence la masse ;
un troisième transistor (T3) connecté entre la première borne (102) de la source de courant (100) et une deuxième sortie différentielle (OUT2-) ; et
un circuit (106) configuré pour :
- appliquer une composante alternative d'une première entrée différentielle (IN+) à la grille du premier transistor (T1),
- appliquer une composante alternative d'une deuxième entrée différentielle (IN-) à la grille du deuxième transistor (T2), et
- appliquer une deuxième tension continue (Vbias) à la grille du troisième transistor (T3),
le doubleur de fréquence étant **caractérisé en ce qu'**il est configuré pour appliquer une première tension continue à la grille du premier transistor (T1) et à la grille du deuxième transistor (T2) et **en ce qu'**il comprend une boucle de contre réaction (108) configurée pour asservir la première tension ou la deuxième tension (Vbias) à partir d'un écart entre les composantes continues des première et deuxième sorties différentielles (OUT2+, OUT2-) de manière à rendre égale lesdites composantes continues.

2. Doubleur radiofréquence selon la revendication 1, dans lequel la boucle de contre réaction (108) est configurée pour fournir une tension de sortie (Verr) représentative dudit écart.

3. Doubleur radiofréquence selon la revendication 2, dans lequel la boucle de contre réaction (108) comprend une première entrée (1081) couplée, par exemple connectée, à la première sortie différentielle (OUT2+), une deuxième entrée (1082) couplée, par exemple connectée, à la deuxième sortie différentielle (OUT2-) et une sortie (1083) configurée pour fournir ladite tension de sortie (Verr).

4. Doubleur radiofréquence selon la revendication 3, dans lequel la boucle de contre réaction (108) comprend :
un amplificateur opérationnel (200) ;
une capacité (C1) connectée entre une entrée non inverseuse (+) de l'amplificateur (200) et ledit potentiel d'alimentation ;
une capacité (C2) connectée entre une entrée inverseuse (-) de l'amplificateur (200) et une sortie de l'amplificateur (200) ;
une première résistance (R2) couplant l'entrée non inverseuse (+) à la première entrée (1081) de la boucle de contre réaction (108) lorsque la première tension est asservie par la boucle de contre réaction, ou à la deuxième entrée (1082) de la boucle de contre réaction (108) lorsque la deuxième tension (Vbias) est asservie par la boucle de contre réaction ; et
une deuxième résistance (R1) couplant l'entrée inverseuse (-) à la deuxième entrée (1082) de la boucle de contre réaction (108) lorsque la première tension est asservie par la boucle de contre réaction, ou à la deuxième entrée de la boucle de contre réaction (108) lorsque la deuxième tension (Vbias) est asservie par la boucle de contre réaction.

5. Doubleur radiofréquence selon l'une quelconque des revendications 2 à 4, dans lequel le circuit (106) est configuré pour fournir la première tension à partir de la tension de sortie (Verr) de la boucle de contre réaction (108) lorsque la première tension est asservie par la boucle de contre réaction, ou pour fournir la deuxième tension (Vbias) à partir de la tension de sortie (Verr) de la boucle de contre réaction (108) lorsque la deuxième tension (Vbias) est asservie par la boucle de contre réaction.

6. Doubleur radiofréquence selon l'une quelconque des revendications 2 à 5, dans lequel le circuit (106) est configuré pour recevoir la tension de sortie (Verr) de la boucle de contre réaction (108).

7. Doubleur radiofréquence selon la revendication 5 ou 6, dans lequel ledit circuit (106) comprend une sortie (1065) connectée à la grille du troisième transistor (T3), ladite sortie (1065) étant configurée pour fournir la tension de sortie (Verr) de la boucle lorsque la deuxième tension (Vbias) est asservie par la boucle de contre réaction (108) ou une tension de polarisation (V1) constante lorsque la première tension est asservie par la boucle de contre réaction.

8. Doubleur radiofréquence selon la revendication 7, dans lequel le circuit (106) comprend :
une première capacité (C3) couplant la première entrée différentielle (IN+) à la grille du premier transistor (T1) ;
une deuxième capacité (C4) couplant la deuxième entrée différentielle (IN-) à la grille du deuxième transistor (T2) ;
une première résistance (R3) couplant la grille du premier transistor (T1) à un premier noeud (204) configuré pour recevoir la tension de sortie (Verr) de la boucle de contre réaction (108) lorsque la première tension est asservie par ladite boucle (108) ou la tension de polarisation (V1) lorsque la deuxième tension (Vbias) est asservie par ladite boucle (108) ;
une deuxième résistance (R4) couplant la grille du deuxième transistor (T2) au premier noeud (204) ; et
une troisième capacité (C5) couplant le premier noeud (204) audit potentiel d'alimentation.

9. Doubleur de fréquence selon la revendication 7, dans lequel le circuit (106) comprend un transformateur ayant son primaire couplé aux première et deuxième entrées différentielles (IN+, IN-), et son secondaire couplé aux grilles des premier et deuxième transistors (T1, T2), le secondaire étant configuré pour être polarisé par la tension de sortie (Verr) de la boucle de contre réaction (108) lorsque la première tension est asservie par ladite boucle (108) ou par la tension de polarisation (V1) lorsque la deuxième tension (Vbias) est asservie par ladite boucle.

10. Doubleur radiofréquence selon l'une quelconque des revendication 7 à 9, dans lequel le circuit (106) comprend une quatrième capacité (C6) couplant ladite sortie (1065) du circuit (106) au potentiel d'alimentation.

11. Tripleur radiofréquence (4) comprenant :
un doubleur radiofréquence (1) selon l'une quelconque des revendications 1 à 10 ; et
un mélangeur radiofréquence (400) configuré pour mélanger un premier signal radiofréquence et un deuxième signal radiofréquence, le mélangeur radiofréquence comprenant une première paire d'entrées différentielles (IN1+, IN1-) configurées pour recevoir le premier signal et une deuxième paire d'entrées différentielles (IN2+, IN2-) configurées pour recevoir le deuxième signal,
dans lequel la première paire d'entrées différentielles (IN1+, IN1-) est connectée aux première et deuxième entrées différentielles (IN+, IN-) du doubleur radiofréquence (1), et la deuxième paire d'entrées différentielles (IN2+, IN2-) est connectée aux première et deuxième sorties différentielles (OUT2+, OUT2-) du doubleur radiofréquence (1).

12. Tripleur radiofréquence selon la revendication 11, dans lequel le mélangeur radiofréquence (400) comprend :
un premier transistor (T4) connecté entre une première entrée (IN2+) de la deuxième paire d'entrées (IN2+, IN2-) et une première sortie différentielle (OUT3+) du tripleur radiofréquence (4) ;
un deuxième transistor (T5) connecté entre la première entrée (IN2+) de la deuxième paire d'entrées (IN2+, IN2-) et une deuxième sortie différentielle (OUT3-) du tripleur radiofréquence (4) ;
un troisième transistor (T6) connecté entre une deuxième entrée (IN2-) de la deuxième paire d'entrées (IN2+, IN2-) et la première sortie (OUT3+) du tripleur radiofréquence (4) ; et
un quatrième transistor (T7) connecté entre la deuxième entrée (IN2-) de la deuxième paire d'entrées (IN2+, IN2-) et la deuxième sortie (OUT3-) du tripleur radiofréquence (4).

13. Tripleur radiofréquence selon la revendication 12, dans lequel :
une première entrée (IN1+) de la première paire d'entrées différentielles (IN1+, IN1-) est couplée, par exemple connectée, à la grille dudit premier transistor (T4) et à la grille dudit quatrième transistor (T7) ; et
une deuxième entrée (IN1-) de la première paire d'entrées différentielles (IN1+, IN1-) est couplée, par exemple connectée, à la grille dudit deuxième transistor (T5) et à la grille dudit troisième transistor (T6).

14. Tripleur radiofréquence selon la revendication 11 ou 12, dans lequel le mélangeur (400) comprend une charge différentielle (402) couplée entre les première et deuxième sorties différentielles (OUT3+, OUT3-) du tripleur radiofréquence (4) et accordée à une fréquence égale à trois fois une fréquence du premier signal radiofréquence, la charge différentielle comprenant, par exemple :
une capacité (C7) connectée entre les première et deuxième sorties différentielles (OUT3+, OUT3-) du tripleur radiofréquence (4) ;
une première inductance (L1) connectée entre la première sortie différentielle (OUT3+) du tripleur radiofréquence (4) et un noeud (404) configuré pour recevoir un potentiel d'alimentation (Vdd) ; et
une deuxième inductance (L2) connectée entre la deuxième sortie différentielle (OUT3-) du tripleur radiofréquence (4) et ledit noeud (404).

15. Chaine (6) d'émission et/ou de réception radiofréquence comprenant un doubleur radiofréquence (1) selon l'une quelconque des revendications 1 à 10 ou un tripleur radiofréquence (4) selon l'une quelconque des revendications 11 à 14.

## Patentansprüche

1. Ein Hochfrequenzverdoppler (1), der Folgendes aufweist:
einen ersten Transistor (T1) und einen zweiten Transistor (T2), die parallel zwischen einem ersten Differenzausgang (OUT2+) und einem ersten Anschluss (102) einer Stromquelle (100) geschaltet sind, die so konfiguriert ist, dass sie einen Vorspannungsstrom (Ibias) liefert, wobei ein zweiter Anschluss der Stromquelle (100) mit einem Versorgungspotential, vorzugsweise Masse, verbunden ist;
einen dritten Transistor (T3), der zwischen dem ersten Anschluss (102) der Stromquelle (100) und einem zweiten Differenzausgang (OUT2-) geschaltet ist; und
eine Schaltung (106), die konfiguriert ist zum:
- Anlegen einer Wechselstromkomponente eines ersten Differenzeingangs (IN+) an das Gate des ersten Transistors (T1),
- Anlegen einer Wechselstromkomponente eines zweiten Differenzeingangs (IN-) an das Gate des zweiten Transistors (T2), und
- Anlegen einer zweiten Gleichspannung (Vbias) an das Gate des dritten Transistors (T3),
wobei der Frequenzverdoppler **dadurch gekennzeichnet ist, dass**
er so konfiguriert ist, dass er eine erste Gleichspannung an das Gate des ersten Transistors (T1) und an das Gate des zweiten Transistors (T2) anlegt, und dass
er eine Rückkopplungsschleife (108) aufweist, die so konfiguriert ist, dass sie die erste Spannung oder die zweite Spannung (Vbias) aus einer Differenz zwischen den Gleichstromkomponenten des ersten und des zweiten Differenzausgangs (OUT2+, OUT2-) steuert, um die genannten Gleichstromkomponenten auszugleichen.

2. Der Hochfrequenzverdoppler gemäß Anspruch 1, wobei die Rückkopplungsschleife (108) so konfiguriert ist, dass sie eine Ausgangsspannung (Verr) liefert, die für die Differenz repräsentativ ist.

3. Der Hochfrequenzverdoppler gemäß Anspruch 2, wobei die Rückkopplungsschleife (108) einen ersten Eingang (1081), der mit dem ersten Differenzausgang (OUT2+) gekoppelt, beispielsweise verbunden, ist, einen zweiten Eingang (1082), der mit dem zweiten Differenzausgang (OUT2-) gekoppelt, beispielsweise verbunden, ist, und einen Ausgang (1083), der so konfiguriert ist, dass er die Ausgangsspannung (Verr) liefert, aufweist.

4. Der Hochfrequenzverdoppler gemäß Anspruch 3, wobei die Rückkopplungsschleife (108) Folgendes aufweist:
einen Operationsverstärker (200);
einen Kondensator (C1), der zwischen einem nicht invertierenden Eingang (+) des Verstärkers (200) und dem Versorgungspotential verbunden ist;
einen Kondensator (C2), der zwischen einem invertierenden Eingang (-) des Verstärkers (200) und einem Ausgang des Verstärkers (200) verbunden ist;
einen ersten Widerstand (R2), der den nichtinvertierenden Eingang (+) mit dem ersten Eingang (1081) der Rückkopplungsschleife (108) koppelt, wenn die erste Spannung durch die Rückkopplungsschleife gesteuert wird, oder mit dem zweiten Eingang (1082) der Rückkopplungsschleife (108), wenn die zweite Spannung (Vbias) durch die Rückkopplungsschleife gesteuert wird; und
ein zweiter Widerstand (R1), der den invertierenden Eingang (-) mit dem zweiten Eingang (1082) der Rückkopplungsschleife (108) koppelt, wenn die erste Spannung durch die Rückkopplungsschleife gesteuert wird, oder mit dem zweiten Eingang der Rückkopplungsschleife (108), wenn die zweite Spannung (Vbias) durch die Rückkopplungsschleife gesteuert wird.

5. Der Hochfrequenzverdoppler gemäß einem der Ansprüche 2 bis 4, wobei die Schaltung (106) so konfiguriert ist, dass sie die erste Spannung aus der Ausgangsspannung (Verr) der Rückkopplungsschleife (108) liefert, wenn die erste Spannung durch die Rückkopplungsschleife gesteuert wird, oder dass sie die zweite Spannung (Vbias) aus der Ausgangsspannung (Verr) der Rückkopplungsschleife (108) liefert, wenn die zweite Spannung (Vbias) durch die Rückkopplungsschleife gesteuert wird.

6. Der Hochfrequenzverdoppler gemäß einem der Ansprüche 2 bis 5, wobei die Schaltung (106) so konfiguriert ist, dass sie die Ausgangsspannung (Verr) der Rückkopplungsschleife (108) empfängt.

7. Hochfrequenzverdoppler gemäß Anspruch 5 oder 6, wobei die Schaltung (106) einen Ausgang (1065) aufweist, der mit dem Gate des dritten Transistors (T3) verbunden ist, wobei der Ausgang (1065) so konfiguriert ist, dass er die Ausgangsspannung (Verr) der Schleife bereitstellt, wenn die zweite Spannung (Vbias) durch die Rückkopplungsschleife (108) gesteuert wird, oder eine konstante Vorspannung (V1) liefert, wenn die erste Spannung durch die Rückkopplungsschleife gesteuert wird.

8. Der Hochfrequenzverdoppler gemäß Anspruch 7, wobei die Schaltung (106) Folgendes aufweist:
einen ersten Kondensator (C3), der den ersten Differenzeingang (IN+) mit dem Gate des ersten Transistors (T1) koppelt;
einen zweiten Kondensator (C4), der den zweiten Differenzeingang (IN-) mit dem Gate des zweiten Transistors (T2) koppelt;
einen ersten Widerstand (R3), der das Gate des ersten Transistors (T1) mit einem ersten Knoten (204) koppelt, der so konfiguriert ist, dass er die Ausgangsspannung (Verr) der Rückkopplungsschleife (108), wenn die erste Spannung durch die Schleife (108) geregelt wird, oder die Vorspannung (V1), wenn die zweite Spannung (Vbias) durch die Schleife (108) geregelt wird, empfängt;
einen zweiten Widerstand (R4), der das Gate des zweiten Transistors (T2) mit dem ersten Knoten (204) koppelt; und
einen dritten Kondensator (C5), der den ersten Knoten (204) mit dem Versorgungspotential koppelt.

9. Der Frequenzverdoppler gemäß Anspruch 7, wobei die Schaltung (106) einen Transformator aufweist, dessen Primärseite mit dem ersten und zweiten Differenzeingang (IN+, IN-) gekoppelt ist und dessen Sekundärseite mit den Gates des ersten und zweiten Transistors (T1, T2) gekoppelt ist, wobei die Sekundärseite so konfiguriert ist, dass sie durch die Ausgangsspannung (Verr) der Rückkopplungsschleife (108), wenn die erste Spannung durch die Schleife (108) gesteuert wird, oder durch die Vorspannung (V1), wenn die zweite Spannung (Vbias) durch die Schleife gesteuert wird, vorgespannt wird.

10. Der Hochfrequenzverdoppler gemäß einem der Ansprüche 7 bis 9, wobei die Schaltung (106) einen vierten Kondensator (C6) aufweist, der den Ausgang (1065) der Schaltung (106) mit dem Versorgungspotential koppelt.

11. Ein Hochfrequenzverdreifacher (4), der Folgendes aufweist:
einen Hochfrequenzverdoppler (1) gemäß einem der Ansprüche 1 bis 10; und
einen Hochfrequenz-Mischer (400), der zum Mischen eines ersten Hochfrequenzsignals und eines zweiten Hochfrequenzsignals konfiguriert ist, wobei der Hochfrequenz-Mischer ein erstes Paar von Differenzeingängen (IN1+, IN1-), das zum Empfangen des ersten Signals konfiguriert ist, und ein zweites Paar von Differenzeingängen (IN2+, IN2-), das zum Empfangen des zweiten Signals konfiguriert ist, aufweist,
wobei das erste Paar von Differenzeingängen (IN1+, IN1-) mit dem ersten und dem zweiten Differenzeingang (IN+, IN-) des Hochfrequenzverdopplers (1) verbunden ist und das zweite Paar von Differenzeingängen (IN2+, IN2-) mit dem ersten und dem zweiten Differenzausgang (OUT2+, OUT2-) des Hochfrequenzverdopplers (1) verbunden ist.

12. Der Hochfrequenzverdreifacher gemäß Anspruch 11, wobei der Hochfrequenzmischer (400) Folgendes aufweist:
einen ersten Transistor (T4), der zwischen einem ersten Eingang (IN2+) des zweiten Paares von Eingängen (IN2+, IN2-) und einem ersten Differenzausgang (OUT3+) des Hochfrequenzverdreifachers (4) verbunden ist;
einen zweiten Transistor (T5), der zwischen dem ersten Eingang (IN2+) des zweiten Paares von Eingängen (IN2+, IN2-) und einem zweiten Differenzausgang (OUT3-) des Hochfrequenzverdreifachers (4) verbunden ist;
einen dritten Transistor (T6), der zwischen einem zweiten Eingang (IN2-) des zweiten Paares von Eingängen (IN2+, IN2-) und dem ersten Ausgang (OUT3+) des Hochfrequenzverdreifachers (4) verbunden ist; und
einen vierten Transistor (T7), der zwischen dem zweiten Eingang (IN2-) des zweiten Paares von Eingängen (IN2+, IN2-) und dem zweiten Ausgang (OUT3-) des Hochfrequenz-Triplers (4) verbunden ist.

13. Der Hochfrequenzverdreifacher gemäß Anspruch 12, wobei:
ein erster Eingang (IN1+) des ersten Paares von Differenzeingängen (IN1+, IN1-) mit dem Gate des ersten Transistors (T4) und mit dem Gate des vierten Transistors (T7) gekoppelt, beispielsweise verbunden, ist; und
ein zweiter Eingang (IN1-) des ersten Paares von Differenzeingängen (IN1+, IN1-) mit dem Gate des zweiten Transistors (T5) und mit dem Gate des dritten Transistors (T6) gekoppelt, beispielsweise verbunden, ist.

14. Der Hochfrequenzverdreifacher gemäß Anspruch 11 oder 12, wobei der Mischer (400) eine Differenzlast (402) aufweist, die zwischen dem ersten und dem zweiten Differenzausgang (OUT3+, OUT3-) des Hochfrequenzverdreifachers (4) gekoppelt und auf eine Frequenz abgestimmt ist, die dem Dreifachen einer Frequenz des ersten Hochfrequenzsignals entspricht, wobei die Differenzlast beispielsweise aufweist:
einen Kondensator (C7), der zwischen dem ersten und dem zweiten Differenzausgang (OUT3+, OUT3-) des Hochfrequenzverdreifachers (4) verbunden ist;
eine erste Induktivität (L1), die zwischen dem ersten Differenzausgang (OUT3+) des Hochfrequenzverdreifachers (4) und einem Knoten (404) verbunden ist, der zum Empfangen eines Versorgungspotentials (Vdd) konfiguriert ist; und
eine zweite Induktivität (L2), die zwischen dem zweiten Differenzausgang (OUT3-) des Hochfrequenzverdreifachers (4) und dem Knoten (404) verbunden ist.

15. Eine Hochfrequenz-Sende- und/oder Empfangskette (6), die einen Hochfrequenzverdoppler (1) gemäß einem der Ansprüche 1 bis 10 oder einen Hochfrequenzverdreifacher (4) gemäß einem der Ansprüche 11 bis 14 aufweist.

## Claims

1. A radiofrequency doubler (1) comprising:
a first transistor (T1) and a second transistor (T2) connected in parallel between a first differential output (OUT2+) and a first terminal (102) of a current source (100) configured to provide a bias current (Ibias), a second terminal of the current source (100) being connected to a supply potential, preferably ground;
a third transistor (T3) connected between the first terminal (102) of the current source (100) and a second differential output (OUT2-); and
a circuit (106) configured to:
- apply an AC component of a first differential input (IN+) to the gate of the first transistor (T1),
- apply an AC component of a second differential input (IN-) to the gate of the second transistor (T2), and
- apply a second DC voltage (Vbias) to the gate of the third transistor (T3),
the frequency doubler being **characterized in that** it is configured to apply a first DC voltage to the gate of the first transistor (T1) and to the gate of the second transistor (T2), and **in that** it comprises a feedback loop (108) configured to control the first voltage or the second voltage (Vbias) from a difference between the DC components of the first and second differential outputs (OUT2+, OUT2-) so as to equalize said DC components.

2. The radiofrequency doubler according to claim 1, wherein the feedback loop (108) is configured to provide an output voltage (Verr) representative of said difference.

3. The radiofrequency doubler according to claim 2, wherein the feedback loop (108) comprises a first input (1081) coupled, for example, connected, to the first differential output (OUT2+), a second input (1082) coupled, for example, connected, to the second differential output (OUT2-) and an output (1083) configured to provide said output voltage (Verr).

4. The radiofrequency doubler according to claim 3, wherein the feedback loop (108) comprises:
an operational amplifier (200);
a capacitor (C1) connected between a non-inverting input (+) of the amplifier (200) and said supply potential;
a capacitor (C2) connected between an inverting input (-) of the amplifier (200) and an output of the amplifier (200);
a first resistor (R2) coupling the non-inverting input (+) to the first input (1081) of the feedback loop (108) when the first voltage is controlled by the feedback loop, or to the second input (1082) of the feedback loop (108) when the second voltage (Vbias) is controlled by the feedback loop; and
a second resistor (R1) coupling the inverting input (-) to the second input (1082) of the feedback loop (108) when the first voltage is controlled by the feedback loop, or to the second input of the feedback loop (108) when the second voltage (Vbias) is controlled by the feedback loop.

5. The radiofrequency doubler according to any one of claims 2 to 4, wherein the circuit (106) is configured to provide the first voltage from the output voltage (Verr) of the feedback loop (108) when the first voltage is controlled by the feedback loop, or to provide the second voltage (Vbias) from the output voltage (Verr) of the feedback loop (108) when the second voltage (Vbias) is controlled by the feedback loop.

6. The radiofrequency doubler according to any one of claims 2 to 5, wherein the circuit (106) is configured to receive the output voltage (Verr) of the feedback loop (108).

7. A radiofrequency doubler according to claim 5 or 6, wherein said circuit (106) comprises an output (1065) connected to the gate of the third transistor (T3), said output (1065) being configured to provide the output voltage (Verr) of the loop when the second voltage (Vbias) is controlled by the feedback loop (108) or a constant bias voltage (V1) when the first voltage is controlled by the feedback loop.

8. The radiofrequency doubler according to claim 7, wherein the circuit (106) comprises:
a first capacitor (C3) coupling the first differential input (IN+) to the gate of the first transistor (T1);
a second capacitor (C4) coupling the second differential input (IN-) to the gate of the second transistor (T2);
a first resistor (R3) coupling the gate of the first transistor (T1) to a first node (204) configured to receive the output voltage (Verr) of the feedback loop (108) when the first voltage is controlled by said loop (108) or the bias voltage (V1) when the second voltage (Vbias) is controlled by said loop (108);
a second resistor (R4) coupling the gate of the second transistor (T2) to the first node (204); and
a third capacitor (C5) coupling the first node (204) to said supply potential.

9. The frequency doubler according to claim 7, wherein the circuit (106) comprises a transformer having its primary coupled to the first and second differential inputs (IN+, IN-), and its secondary coupled to the gates of the first and second transistors (T1, T2), the secondary being configured to be biased by the output voltage (Verr) of the feedback loop (108) when the first voltage is controlled by said loop (108) or by the bias voltage (V1) when the second voltage (Vbias) is controlled by said loop.

10. The radiofrequency doubler according to any one of claims 7 to 9, wherein the circuit (106) comprises a fourth capacitor (C6) coupling said output (1065) of the circuit (106) to the supply potential.

11. A radiofrequency tripler (4) comprising:
a radiofrequency doubler (1) according to any one of claims 1 to 10; and
a radiofrequency mixer (400) configured to mix a first radiofrequency signal and a second radiofrequency signal, the radiofrequency mixer comprising a first pair of differential inputs (IN1+, IN1-) configured to receive the first signal and a second pair of differential inputs (IN2+, IN2-) configured to receive the second signal,
wherein the first pair of differential inputs (IN1+, IN1-) is connected to the first and second differential inputs (IN+, IN-) of the radiofrequency doubler (1), and the second pair of differential inputs (IN2+, IN2-) is connected to the first and second differential outputs (OUT2+, OUT2-) of the radiofrequency doubler (1).

12. The radiofrequency tripler according to claim 11, wherein the radiofrequency mixer (400) comprises:
a first transistor (T4) connected between a first input (IN2+) of the second pair of inputs (IN2+, IN2-) and a first differential output (OUT3+) of the radiofrequency tripler (4);
a second transistor (T5) connected between the first input (IN2+) of the second pair of inputs (IN2+, IN2-) and a second differential output (OUT3-) of the radiofrequency tripler (4);
a third transistor (T6) connected between a second input (IN2-) of the second pair of inputs (IN2+, IN2-) and the first output (OUT3+) of the radiofrequency tripler (4); and
a fourth transistor (T7) connected between the second input (IN2-) of the second pair of inputs (IN2+, IN2-) and the second output (OUT3-) of the radiofrequency tripler (4).

13. The radiofrequency tripler according to claim 12, wherein:
a first input (IN1+) of the first pair of differential inputs (IN1+, IN1-) is coupled, for example, connected, to the gate of said first transistor (T4) and to the gate of said fourth transistor (T7); and
a second input (IN1-) of the first pair of differential inputs (IN1+, IN1-) is coupled, for example connected to the gate of said second transistor (T5) and to the gate of said third transistor (T6).

14. The radiofrequency tripler according to claim 11 or 12, wherein the mixer (400) comprises a differential load (402) coupled between the first and second differential outputs (OUT3+, OUT3-) of the radiofrequency tripler (4) and tuned to a frequency equal to three times a frequency of the first radiofrequency signal, the differential load comprising, for example:
a capacitor (C7) connected between the first and second differential outputs (OUT3+, OUT3-) of the radiofrequency tripler (4);
a first inductor (L1) connected between the first differential output (OUT3+) of the radiofrequency tripler (4), and a node (404) configured to receive a supply potential (Vdd); and
a second inductor (L2) connected between the second differential output (OUT3-) of the radiofrequency tripler (4) and said node (404).

15. A radiofrequency transmission and/or reception chain (6) comprising a radiofrequency doubler (1) according to any of claims 1 to 10 or a radiofrequency tripler (4) according to any of claims 11 to 14.
